(19) **Europäisches Patentamt**
**European Patent Office**
**Office européen des brevets**

(11) **EP 1 563 549 B1**

(12) **EUROPÄISCHE PATENTSCHRIFT**

(45) Veröffentlichungstag und Bekanntmachung des Hinweises auf die Patenterteilung:
**16.01.2008 Patentblatt 2008/03**

(21) Anmeldenummer: **03785489.0**

(22) Anmeldetag: **27.10.2003**

(51) Int Cl.:
*H01L 41/083* (2006.01)  *H01L 41/187* (2006.01)
*H01L 41/047* (2006.01)  *H01L 41/24* (2006.01)

(86) Internationale Anmeldenummer:
**PCT/DE2003/003568**

(87) Internationale Veröffentlichungsnummer:
**WO 2004/040664 (13.05.2004 Gazette 2004/20)**

(54) **PIEZOELEKTRISCHES BAUELEMENT**

PIEZOELECTRIC COMPONENT

COMPOSANT PIEZOELECTRIQUE

(84) Benannte Vertragsstaaten:
**DE FR GB**

(30) Priorität: **25.10.2002 DE 10249900**

(43) Veröffentlichungstag der Anmeldung:
**17.08.2005 Patentblatt 2005/33**

(73) Patentinhaber: **EPCOS AG**
**81669 München (DE)**

(72) Erfinder:
 • **FLORIAN, Heinz**
 **A-8524 Bad Gams (AT)**
 • **OTTLINGER, Marion**
 **A-8530 Deutschlandsberg (AT)**

(74) Vertreter: **Epping - Hermann - Fischer**
**Ridlerstrasse 55**
**80339 München (DE)**

(56) Entgegenhaltungen:
 **WO-A-01/45138**   **WO-A-02/055450**

 • **REMIENS D ET AL: "Piezoelectric properties of sputtered PZT films: influence of structure, micro structure, film thickness (Zr,Ti) ratio and Nb substitution" MATERIALS SCIENCE IN SEMICONDUCTOR PROCESSING, ELSEVIER SCIENCE PUBLISHERS B.V., BARKING, UK, Bd. 5, Nr. 2-3, April 2002 (2002-04), Seiten 123-127, XP004412123 ISSN: 1369-8001**
 • **ZOU Q ET AL: "Microstructural characterization of donor-doped lead zirconate titanate films prepared by sol-gel processing" PREPARATION AND CHARACTERIZATION, ELSEVIER SEQUOIA, NL, Bd. 402, Nr. 1-2, 1. Januar 2002 (2002-01-01), Seiten 65-70, XP004329935 ISSN: 0040-6090**
 • **BARLINGAY C K ET AL: "Observation of sol-gel solid phase epitaxial growth of ferroelectric Pb(Nb,Zr,Ti)O/sub 3/ thin films on sapphire" APPLIED PHYSICS LETTERS, 14 SEPT. 1992, USA, Bd. 61, Nr. 11, Seiten 1278-1280, XP002271639 ISSN: 0003-6951**
 • **BARLINGAY C K ET AL: "Dopant compensation mechanism and leakage current in Pb(Zr/sub 0.52/,Ti/sub 0.48/)O/sub 3/ thin films" THIN SOLID FILMS, 1 JAN. 1996, ELSEVIER, SWITZERLAND, Bd. 272, Nr. 1, Seiten 112-115, XP002271640 ISSN: 0040-6090**

Printed by Jouve, 75001 PARIS (FR)

**Beschreibung**

Die Erfindung betrifft die Entwicklung piezoelektrischer Keramikmassen für die Anwendung in Vielschichtbauelementen mit Cu - Innenelektroden, die sich durch eine geringe Verlustleistung bei guter Auslenkung auszeichnen. Die Erfindung betrifft insbesondere ein piezoelektrisches Bauelement gemäß dem Oberbegriff des Anspruchs 1 sowie ein Herstellungsverfahren gemäß Anspruch 5.

Eine aus der WO 01/45138 bekannte Lösung basiert auf der Anwendung einer Keramikmasse der Zusammensetzung $Pb_{0,97}Nd_{0,02}(Zr_{0,5515}Ti_{0,4485})O_3$ in Piezostacks mit Cu-Innenelektroden, deren Herstellung durch Entbinderung und Sinterung an der Luft vorgenommen wird.

In der folgenden Zusammenstellung sind die Eigenschaften der bekannten Aktoren mit der Keramikzusammensetzung $Pb_{0,97}Nd_{0,02}(Zr_{0,5515}Ti_{0,4485})O_3$ mit jeweils 360 Innenelektroden und einer Keramikschichtdicke von 80 $\mu$m in Gemeinsamsinterung mit Cu - Innenelektroden zusammengestellt, wie sie nach einer Polung mit E = 2 kV/mm (a) bei Raumtemperatur und (b) bei 180°C gemessen werden. Neben den Kleinsignaleigenschaften der Dielektrizitätskonstanten (DK) und der Temperaturabhängigkeit der DK ist hier auch die Großsignal - Dielektrizitätskonstante angegeben, die sich aus der Polarisation durch eine Spannung berechnen läßt, welche z. B. bei den Aktoren zu einer Auslenkung von 40 $\mu$m führt.

|   | Kleinsignal DK | Großsignal DK | TK ppm/K | $d_{33}$ pm/V | Wg % | E mJ |
|---|---|---|---|---|---|---|
| a | 1214 $\pm$ 30 | 3110 $\pm$ 87 | 3936 $\pm$ 82 | 592 $\pm$ 18 | 50,4 $\pm$ 0,4 | 50 $\pm$ 2 |
| b |  | 2772 $\pm$ 50 |  | 632 $\pm$ 11 | 56,5 $\pm$ 0,4 | 34 $\pm$ 1 |

Durch die Polung bei höherer Temperatur kann der Wirkungsgrad von 50% auf 56% verbessert und die Verlustenergie von 50 mJ auf 34 mJ erniedrigt werden.

Es wird erfindungsgemäß ein piezoelektrisches Bauelement gemäß Anspruch 1 angegeben. Insbesondere wird eine Keramikmasse der Zusammensetzung $Pb_{0,988}V_{0,012}(Zr_{0,504+x}Ti_{0,472-x}Nb_{0,024})O_{3,000}$ angegeben, wobei -0,05 s x s 0,05.

Zusätzliche vorteilhafte Aspekte der Erfindung sind ferner:

1. Einstellung des Ti/ Zr - Verhältnisses auf die morphotrope Phasengrenze

2. Einbau von $Nb^{5+}$ auf Zr/Ti - Plätzen in der Perowskitstruktur mit Donatorfunktion nach der Zusammensetzung $Pb_{0,988}V_{0,012}(Zr_{0,504+x}Ti_{0,472-x}Nb_{0,024})O_{3,000}$, wobei V für eine Vakanz steht

3. Zusammensinterung mit Cu - Innenelektroden bei 1000°C

Weitere Vorteile liegen in:

1.   Im Nachweis, daß eine Nb - dotierte, Ag - freie Keramik der Zusammensetzung $Pb_{0,988}V_{0,012}Zr_{0,504+x}Ti_{0,472-x}Nb_{0,024}O_3$ vorteilhafterweise an die morphotrope Phasengrenze angepaßt wird. Mit der Formel $Pb_{0,988}V_{0,012}Zr_{0,504}Ti_{0,472}Nb_{0,024}O_3$ wurde die geeignete analytische Zusammensetzung erreicht, die zu geringen piezoelektrischen Verlusten bei akzeptabler Auslenkung führt.

2. Durch den definierten Einbau von $Cu_2O$ während des Sinterns und die Steuerung des Korngrößenwachstums durch den Nb-Einbau und die entsprechende Sintertemperatur werden Auslenkung und Verlustenergie des Aktors bestimmt.

3. Der Einbau von $Nb_2O_5$ gelingt schon während des Umsatzes der Rohstoffmischung gemeinsam mit den übrigen Oxidrohstoffen an Luft bei 925°C.

4. Nach der Sinterung der Keramik
$Pb_{0,988}V_{0,012}Zr_{0,504}Ti_{0,472}Nb_{0,024}O_3$ mit Cu - Innenelektroden
unter vermindertem Sauerstoffpartialdruck, wie er dem Gleichgewicht $Cu/Cu_2O$ entspricht, zeigt die dielektrische Konstante über der Temperatur eine geringere Abhängigkeit als bei Verwendung einer Nd dotierten Keramikmasse $Pb_{0,97}V_{0,01}Zr_{0,55515}Ti_{0,4485}O_3$.

Ausführungsbeispiele werden im folgenden beschrieben.

Die aus TiO2, ZrO2 bzw. einem durch Mischfällung hergestellten Precursor (Zr,Ti)O2 und PbCO3 bzw.Pb3O4 und Dotanden wie Nb2O5 oder einem anderen Oxid der Seltenerdmetalle bestehende Rohstoffmischung wird mit einer Zusammensetzung, die der morphotropen Phasengrenze entspricht und einem PbO - Überschuß von maximal 5 % zur Förderung der Sinterverdichtung eingewogen, zur Gleichverteilung der Komponenten in wässriger Suspension einer Mahlstufe unterzogen und nach dem Filtrieren und Trocknen bei 900 bis 950°Can der Luft kalziniert. Dabei bildet sich eine piezokeramische Perowskit-Mischkristallphase. Um bereits bei 1000°C unterhalb der Schmelztemperatur von Kupfer in 2 - 8 Stunden Sinterverdichtung zu erreichen, ist eine Feinmahlung bis auf eine mittlere Korngröße von 0,4-0,6 $\mu$m erforderlich. Die Sinteraktivität des Pulvers erweist sich dann als ausreichend, um eine Verdichtung > 97% der theoretischen Dichte bei zugleich hinreichendem Kornwachstum und ausreichender mechanischer Festigkeit im Keramikgefüge zu ergeben.

Das fein gemahlene Pulver wird unter Verwendung eines Dispergators zu einem wässrigen Schlicker mit ca. 70 m% Feststoffgehalt, das entspricht etwa 24 Vol. - %, suspensiert. Dabei wird der für eine optimale Dispergierung gerade notwendige Dispergatoranteil in einer Versuchsreihe gesondert ermittelt, was am Erreichen eines Viskositätsminimums erkannt werden kann. Man fügt für die Ausbildung der Piezokeramik - Grünfolien zu den dispergierten Feststoffpulversuspensionen ca. 6 m-% eines handelsüblichen Binders, der thermohydrolytisch abbaubar ist, hinzu. Dafür erweist sich eine wässrige Polyurethandispersion als vorteilhaft. Man mischt zum Beispiel in einer Dispermat - Mühle und erhält auf diesem Weg einen für den Folienziehprozeß bzw. für die Herstellung eines Sprühgranulats geeigneten Schlicker.

Scheibenförmige Preßlinge, hergestellt aus dem Granulat, oder Mehrlagenplättchen "MLP", durch übereinanderstapeln und Laminieren aus den 40 bis 50 $\mu$m dicken Grünfolien ohne Bedrukkung mit Cu - Elektrodenpaste gewonnen, lassen sich in einer H2O - Dampf enthaltenden Inertgasatmosphäre bei einem definierten Sauerstoffpartialdruck, der die Bedingung der Koexistenz von PbO -enthaltender Piezokeramik und Kupfer erfüllt, bis auf einen Restkohlenstoff von < 300 ppm entbindern.

Die hydrolytische Spaltung des Binders erfolgt zum Hauptteil bei der relativ niedrigen Temperatur von 220 $\pm$ 50°C bei einem Wasserdampfpartialdruck größer 200 mbar. Der Sauerstoffpartialdruck wird auf einen Wert eingestellt, der mit den Cu-haltigen Elektroden verträglich ist. Dies erfolgt durch das Gettern des Sauerstoffs aus dem Gasstrom an großen Oberflächen von Cu oder durch Zudosierung von Wasserstoff. Zwar tragen die Elektrodenschichten zu einer Entbinderung insofern bei, als durch sie bevorzugte Wege für einen Bindemittelabtransport gegeben sind, allerdings ist dennoch insbesondere für Aktoren mit großer Anzahl von Elektroden eine beträchtliche Entbinderungszeit nötig.

Die elektrischen Eigenschaften der kompakten Proben in den Reihen variabler Zusammensetzung und die von Aktoren mit Cu-

Innenelektroden bei optimierter Keramikzusammensetzung sind in den folgenden Tabellen angegeben.

Tabelle 1: Eigenschaften kompakter quadratischer Keramikproben MLP (Kantenlänge a=11,5 mm, Dicke h=1mm) in der Reihe $Pb_{0,988}V_{0,012}(Zr_{0,504+x}Ti_{0,472-x}Nb_{0,024})O_{3,000}$ zwecks Ermittlung der morphotropen Phasengrenze mit Angabe des mittleren statistischen Fehlers aus jeweils 5 Einzelproben nach Sinterung bei 1000°C

| Polungsart | x | $\varepsilon$ (2kV/mm) | $d_{33}$ [pm/V] | Eloss/V [mJ/mm$^3$] | $\eta$ [%] |
|---|---|---|---|---|---|
| 25°C/ E = 2kV/mm | 0 | 3043 $\pm$ 47 | 572 $\pm$ 12 | 31086 $\pm$ 323 | 44 $\pm$ 0,5 |
| | + 0,01 | 3469 $\pm$ 64 | 524 $\pm$ 6 | 43313 $\pm$ 2169 | 30 $\pm$ 2 |
| | - 0,01 | 2926 $\pm$ 94 | 390 $\pm$ 13 | 38801 $\pm$ 1334 | 26 $\pm$ 0,2 |
| 120°C/ 3kV/mm | 0 | 2253 $\pm$ 133 | 518 $\pm$ 8 | 14378 $\pm$ 1628 | 57 $\pm$ 2 |
| | + 0,01 | 2225 $\pm$ 65 | 464 $\pm$ 15 | 39035 $\pm$ 2305 | 37 $\pm$ 2 |
| | - 0,01 | 1676 $\pm$ 42 | 409 $\pm$ 27 | 24627 $\pm$ 2504 | 48 $\pm$ 5 |

Man erkennt, daß der d33 - Wert bei x = 0 einen Maximalwert durchläuft. Die Zusammensetzung für dieses Ti/ Zr - Verhältnis weist auch die geringste Verlustenergie auf. Demnach entspricht die Formel $Pb_{0,988}V_{0,012}(Zr_{0,504}Ti_{0,472}Nb_{0,024})O_{3,000}$ einer Keramikmasse, die an die morphotrope Phasengrenze angepaßt ist. Durch die Polung bei 120°C und höherer Feldstärke verringert sich die Verlustenergie.

In Tabelle 2 und 3 sind die Eigenschaften der aufgebauten Aktoren mit Cu-Innenelektroden mit Anpassung an die morphotrope Phasengrenze beschrieben.

Tabelle 2: Leistungsdaten der Piezoaktoren

| Größen | Einheit | Verlustarme Keramik im Aktor |
|---|---|---|
| Geometrie: Stack | mm$^3$ | 6.8x6.8x30 |
| Hub in Rohrfeder | μm | 30 |
| Zahl der Einzelschichten | | 360 |
| Einzelschichtdicke (gesintert) | μm | 75 |
| Kleinsignalkapazität gepolt | μF | 2,9 ± 0,05 |
| Verlustwinkel tan δ | | 0,010 ± 0,001 |
| Gesamtenergie für 30 μm Hub | mJ | 57,8 ± 1,0 |
| Spannung U30 für 30 μm Hub | V | 162 ± 2 |
| Großsignalkapazität | μF | 4,39 ± 0,07 |
| Temperaturabhängigkeit der Kleinsignalkapazität (gepolt) im Temperaturbereich zwischen 20°C und 60°C | ppm/ K | 2335 ± 342 |
| Verlustenergie pro 30 μm-Hub | mJ | 19,1 ± 0,5 |
| Ansteuerfeldstärke für 30 μm-Hub | V/mm | 2160 ± 27 |
| $d_{33}$ bei Ansteuerfeldstärke | pm/V | 510 ± 42 |
| Ladung Q30 für 30 μm Hub | mC | 0,712 ± 0,005 |
| Wirkungsgrad für 30 μm Hub | % | 67,0 ± 0,6 |

Tabelle 3: Ergebnisse durchgeführter Dauertests

| Größen | Einheit | Änderung nach $4.6 \times 10^8$ Zyklen |
|---|---|---|
| Spannung U30 | V | + (4,7 ± 0,9) % |
| Ladung Q30 für 3 0 μm Hub | mC | - (2, 6 ± 1,7) % |
| Energie für 30 μm Hub | mJ | - (3 ± 3) % |
| Verlustenergie pro 30 μm Hub | mJ | - (12 ± 6) % |

Die Werte in Tabelle 2 lassen im Vergleich der Aktoren mit der Keramik $Pb_{0,97}V_{0,02}(Nd_{0,02}Zr_{0,5515}Ti_{0,4485})O_{3,000}$ eine Eigenschaftsverbesserung hinsichtlich der piezoelektrischen Verluste und der Temperaturabhängigkeit der Kleinsignalkapazität erkennen. Bei einer Auslenkung der Aktoren um 30μm wird eine Verlustenergie von 20 mJ gemessen. Die Temperaturabhängigkeit der dielektrischen Kleinsignalkapazität im Bereich zwischen 20°C und 60°C ist deutlich geringer als bei Verwendung der Nd - dotierten Keramikmasse. Die Ergebnisse der Dauerlauftests sind in Tabelle 3 angegeben.

In Tabelle 4 werden Ergebnisse gesinterter und passivierten Aktoren gegenübergestellt, wenn der Druck auf den Aktor variiert. Während die Energie, die zur Dehnung von 30 μm notwendig ist, zwischen 500 und 1000 N gleich groß bleibt, erhöht sich der Wirkungsgrad von 61% auf 63% tendenziell.

Tabelle 4: Druckabhängigkeit des Wirkungsgrades, gemessen an gesinterten Aktoren nach einer Polung bei Raumtemperatur mit einer Feldstärke von 2kV/mm

| Kraft [N] | U30 [V] | EPS groß | E [mWs] | Q [mAs] | Wg [%] | Eloss [mWs] |
|---|---|---|---|---|---|---|
| 500 | 190 ± 3 | 2126 ± 54 | 76 ± 4 | 0,80 ± 0,03 | 61 ± 1 | 30 ± 2 |
| 800 | 191 ± 2 | 2120 ± 41 | 76 ± 3 | 0,79 ± 0,02 | 62,5 ± 0,4 | 28 ± 1 |
| 1000 | 191 ± 1 | 2131 ± 38 | 76 ± 2 | 0,80 ± 0,02 | 63,0 ± 0,5 | 28 ± 1 |

Es hat sich gezeigt, daß die mittlere gesinterte Korngröße 0,7 - 1,0$\mu$m beträgt und daß die Innenelektroden frei von Löchern sind.

**Patentansprüche**

1. Piezoelektrisches Bauelement in monolithischer Vielschichtbauweise mit einem Stapel aus übereinanderliegenden Keramikschichten und wenigstens zwei dazwischenliegenden Elektrodenschichten, bei dem die Elektrodenschichten elementares Kupfer enthalten und bei dem die Keramikschichten ein dotiertes Blei-Zirkonat-Titanat enthalten, **dadurch gekennzeichnet, dass** die Dotierung im Wesentlichen aus Niob besteht.

2. Bauelement nach Anspruch 1, bei dem die Keramikschichten ein Material der Zusammensetzung $Pb_{0,988}V_{0,012}(Zr_{0,504+x}Ti_{0,472-x}Nb_{0,024})O_{3,000}$ enthalten, wobei V für eine Vakanz steht und wobei gilt:

$$-0,05 \leq x \leq 0,05.$$

3. Bauelement nach Anspruch 1, bei dem die Keramikschichten ein Ag-freies Material enthalten.

4. Bauelement nach Anspruch 1 oder 3,
wobei die Zusammensetzung der Keramik an die morphotrope Phasengrenze angepasst ist.

5. Verfahren zur Herstellung eines Bauelements nach einem der Ansprüche 1 bis 4,
wobei das Keramikmaterial in einer $H_2O$-Dampf enthaltenden Inertgasatmosphäre entbindert wird.

6. Verfahren nach Anspruch 5,
wobei das Keramikmaterial bei einer Temperatur von 220 $\pm$ 50°C bei einem Wasserdampfpartialdruck > 200 mbar entbindert wird.

7. Verfahren nach Anspruch 5 oder 6,
wobei bei der Entbinderung des Keramikmaterials der Sauerstoffpartialdruck auf einen Wert eingestellt wird, der r die Bedingung der Koexistenz von PbO-haltige Piezokeramik und Kupfer erfüllt.

8. Verfahren nach einem der Ansprüche 5 bis 7,
wobei das Keramikmaterial unter Zudosierung von Wasserstoff entbindert wird.

**Claims**

1. Piezoelectric component of monolithic multilayer design with a stack of ceramic layers lying one above another and at least two intervening electrode layers,
in which the electrode layers contain elemental copper and in which the ceramic layers contain a doped lead zirconate titanate, **characterized in that** the doping substantially comprises niobium.

2. Component according to Claim 1,
in which the ceramic layers contain a material having the composition $Pb_{0.988}V_{0.012}(Zr_{0.504+x}Ti_{0.472-x}Nb_{0.024})O_{3.000}$, where V denotes a vacancy and where the following holds true:

$$-0.05 \leq x \leq 0.05.$$

3. Component according to Claim 1,
in which the ceramic layers contain an Ag-free material.

4. Component according to Claim 1 or 3,
wherein the composition of the ceramic is adapted to the morphotropic phase boundary.

**5.** Method for producing a component according to one of Claims 1 to 4,
wherein the ceramic material is subjected to binder removal in an inert gas atmosphere containing $H_2O$ vapour.

**6.** Method according to Claim 5,
wherein the ceramic material is subjected to binder removal at a temperature of $220 \pm 50°C$ at a water vapour partial pressure > 200 mbar.

**7.** Method according to Claim 5 or 6,
wherein, when the ceramic material is subjected to binder removal, the oxygen partial pressure is set to a value which meets the condition of coexistence of PbO-containing piezoceramic and copper.

**8.** Method according to one of Claims 5 to 7,
wherein the ceramic material is subjected to binder removal with metered addition of hydrogen.

**Revendications**

**1.** Composant piézoélectrique en mode de construction monolithique à plusieurs couches , comprenant un empilement de couches de céramique superposées et au moins deux couches d' électrodes interposées , dans lequel les couches d' électrodes contiennent du cuivre élémentaire et dans lequel les couches de céramique contiennent un zirconate-titanate de plomb dopé , **caractérisé en ce que** le dopage consiste essentiellement en niobium.

**2.** Composant suivant la revendication 1,
dans lequel les couches en céramique contiennent une matière ayant la composition $Pb_{0,988}V_{0,012}$ $(Zr_{0,504+x}Ti_{0,472}-xNb_{0,024})O_{3,000}$, V représentant une vacance et on a :

$$-0,05 \leq x \leq 0,05.$$

**3.** Composant suivant la revendication 1,
dans lequel les couches en céramique contiennent une matière exempte d' Ag .

**4.** Composant suivant la revendication 1 ou 3 ,
dans lequel la composition de la céramique et adaptée à la limite de phase morphotrope .

**5.** Procédé de production d' un composant suivant 1' une des revendications 1 à 4,
dans lequel on élimine le liant de la matière céramique dans une atmosphère de gaz inerte contenant de la vapeur d' $H_2O$.

**6.** Procédé suivant la revendication 5 ,
dans lequel on élimine le liant de la matière en céramique à une température de $220 \pm 50°C$ sous une pression partielle de vapeur d'eau > 200 mbar.

**7.** Procédé suivant la revendication 5 ou 6,
dans lequel , lorsque l'on élimine le liant de la matière en céramique , on règle la pression partielle de l' oxygène à une valeur qui satisfait à la condition de coexistence de piézocéramique contenant du PbO et du cuivre.

**8.** Procédé suivant l'une des revendications 5à 7,
dans lequel on élimine le liant de la matière en céramique en ajoutant de l' hydrogène de manière dosée.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0145138 A